# EUROPÄISCHE PATENTSCHRIFT

(11) **EP 2 631 604 B1**
(45) Veröffentlichungstag und Bekanntmachung des Hinweises auf die Patenterteilung: **11.01.2017**
(21) Anmeldenummer: 12191732.2
(22) Anmeldetag: 08.11.2012
(51) Int. Cl.: G01D 5/244, G05B 19/042

(54) **Positionsmesseinrichtung**
Position measuring device
Dispositif de mesure de position

(30) Priorität: 03.02.2012 DE 102012201651
(43) Veröffentlichungstag der Anmeldung: 28.08.2013
(73) Patentinhaber: Dr. Johannes Heidenhain GmbH, 83301 Traunreut (DE)
(72) Erfinder: Strasser, Erich, 83308 Trostberg (DE)

(56) Entgegenhaltungen:
- EP-A1- 0 660 209
- DE-A1-102008 054 887

## Beschreibung

Die Erfindung betrifft eine Positionsmesseinrichtung nach dem Oberbegriff des Anspruchs 1.

Eine derartige Positionsmesseinrichtung dient zur Bestimmung der Lage zweier zueinander bewegbarer Objekte und erzeugt im Betrieb (elektrische) Ausgangssignale, die (in digitaler Form) als Positionsmesswerte (Positionsdaten) einer Steuer- bzw. Verarbeitungseinheit zugeführt werden, in welcher die Positionsmesswerte ausgewertet und z.B. zur Steuerung einer Werkzeugmaschine genutzt werden. Umgekehrt überträgt regelmäßig auch die Steuer- bzw. Verarbeitungseinheit Daten an die Positionsmesseinrichtung, etwa in Form von Positionsanforderungsbefehlen, mit denen die Übertragung von Positionsmesswerten der Positionsmesseinrichtung an die Steuerbzw. Verarbeitungseinheit ausgelöst wird, oder in Form von Parameterdaten, die für den Betrieb der Positionsmesseinrichtung von Bedeutung sind. Es handelt sich also um eine Positionsmesseinrichtung zur Bestimmung der Lage zweier zueinander bewegbarer Objekte, die über einen Datenübertragungskanal mit einer Steuer- bzw.Verarbeitungseinheit zu verbinden ist.

Der Datenübertragungskanal, welcher eine physikalische Verbindung zwischen der Positionsmesseinrichtung und der Steuer- bzw. Verarbeitungseinheit herstellt und hierdurch eine Datenübertragung zwischen jenen beiden Baugruppen ermöglicht, wird zusammen mit den als Protokoll bezeichneten Regeln der Datenübertragung auch als Schnittstelle bezeichnet.

Für die Datenübertragung zwischen einer Positionsmesseinrichtung und einer zugehörigen Steuer- bzw. Verarbeitungseinheit sind unterschiedliche Schnittstellen bekannt. Die Art der verwendeten Schnittstelle kann zum einen davon abhängen, ob es sich bei der Positionsmesseinrichtung um eine inkrementale Positionsmesseinrichtung handelt, mit der Positionsänderungen zweier zueinander bewegbarer Objekte erfasst werden, woraus sich durch Bezugnahme auf eine Referenzposition (welche in einer anfänglichen Referenzfahrt der Positionsmesseinrichtung ermittelbar ist) ggf. auch absolute Positionen bestimmen lassen, oder ob es sich um eine absolutePositionsmesseinrichtung handelt, mit der unmittelbar die Lage des einen der beiden Objekte zum anderen der beiden Objekte ermittelbar ist. Darüber hinaus kommen aber auch bei vorgegebenem Typ einer Positionsmesseinrichtung (absolut oder inkremental) unterschiedliche Schnittstellen für die Verbindung zu einer Steuer- bzw. Verarbeitungseinheit zum Einsatz.

So werden insbesondere für die Übertragung absoluter Positionsmesswerte von einer Positionsmesseinrichtung zu einer Steuer- bzw. Verarbeitungseinheit hauptsächlich serielle Schnittschnellen eingesetzt, da diese mit nur wenigen Datenübertragungsleitungen hohe Datenübertragungsraten erreichen können. Dies gilt insbesondere für die sogenannten synchron-seriellen Schnittstellen, die eine uni- oder bidirektionale Datenleitung und eine Taktleitung aufweisen. Die Übertragung von Datenpaketen auf der Datenleitung erfolgt dabei synchron zu einem Taktsignal auf der Taktleitung. Beispiele für derartige synchron-serielle Schnittstellen sind die sogenannte EnDat-Schnittstelle sowie SSI.

Die SSI-Schnittstelle ist in der EP 0 171 579 A1 beschrieben. Sie ist ausgestaltet als eine synchron-serielle Schnittstelle mit einer unidirektionalen Datenleitung und einer unidirektionalen Taktleitung. Das Auslesen von Positionsmesswerten aus einer Positionsmesseinrichtung erfolgt hierbei synchron zu einem Taktsignal auf der Taktleitung.

In der EP 0 660 209 A1 sind die Grundlagen der EnDat-Schnittstelle dargelegt. Hierbei handelt es sich ebenfalls um eine synchron-serielle Schnittstelle, die jedoch neben einer unidirektionalen Taktleitung eine bidirektionale Datenleitung aufweist. Dadurch ist die Übertragung von Daten in beide Richtungen, also von der Positionsmesseinrichtung zur Steuer- bzw. Verarbeitungseinheit sowie umgekehrt von der Steuer- bzw. Verarbeitungseinheit zur Positionsmesseinrichtung, möglich. Die Datenübertragung erfolgt auch hier synchron zu einem Taktsignal auf der Taktleitung.

Bei Verwendung der beiden vorgenannten Schnittstellen ist die Positionsmesseinrichtung jeweils über einen Datenübertragungskanal mit der Steuer- bzw. Verarbeitungseinheit verbunden, der durch zwei Leitungspaare gebildet wird. Demgegenüber ist in der DE 10 2008 027902 A1 eine Schnittstellenversion beschrieben, bei der die Positionsmesseinrichtung über nur ein Leitungspaar mit der Steuer- bzw. Verarbeitungseinheit verbunden ist.

Eine gattungsgemäße Positionsmesseinrichtung ist demnach zur Bildung eines Datenübertragungskanales wahlweise über ein erstes Leitungspaar oder über ein erstes und mindestens ein weiteres (zweites) Leitungspaar mit einer Steuer- bzw. Verarbeitungseinheit verbindbar, um Daten übertragen zu können.

Die Steuer- bzw. Verarbeitungseinheit wird dabei nachfolgend auch einfach als Verarbeitungseinheit bezeichnet werden, weil der Empfang und die Verarbeitung der von der Positionsmesseinrichtung gewonnenen und über einen Datenübertragungskanal (Schnittstelle) übertragenen Daten zentrale Funktionen jener Einheit sind. Darüber hinaus kann sie auch zur Steuerung einerseits der Positionsmesseinrichtung dienen und/oder andererseits einer Werkzeugmaschine oder einer sonstigen Baueinheit, die in Abhängigkeit von den mittels der Positionsmesseinrichtung gewonnenen Daten zu steuern ist.

Aus der DE 10 2008 054887 A1 sind eine Vorrichtung und ein Verfahren zur automatisierten Unterscheidung der beiden erstgenannten Schnittstellen, die jeweils Datenübertragungskanäle mit zwei Leitungspaaren umfassen, bekannt. Diese Methode ist jedoch nicht ohne weiteres zur Erkennung von Schnittstellen mit unterschiedlicher Anzahl an Leitungspaaren anwendbar.

Der Erfindung liegt das Problem zugrunde, die Schnittstellenerkennung bei einer Positionsmesseinrichtung der eingangs genannten Art weiter zu verbessern.

Dieses Problem wird erfindungsgemäß durch die Schaffung einer Positionsmesseinrichtung mit den Merkmalen des Anspruchs 1 gelöst.

Danach ist der Positionsmesseinrichtung eine Detektionseinheit zugeordnet, mit der (speziell) ermittelbar ist, ob es sich bei dem Datenübertragungskanal bzw. der Schnittstelle, über welche die Positionsmesseinrichtung aktuell mit einer Steuer- bzw. Verarbeitungseinheit verbunden ist, um eine solche mit nur einem Leitungspaar oder um eine solche mit zwei (oder mehr) Leitungspaaren handelt.

Hierdurch wird eine nachfolgende genauere Identifizierung der Schnittstelle, wie sie beispielsweise in der DE 10 2008 054887 A1 beschrieben ist, vereinfacht.

Die Detektionseinheit kann insbesondere in die Positionsmesseinrichtung integriert sein.

Weiterhin kann die Detektionseinheit so ausgestaltet sein, dass sie ermittelt, ob neben einem (für die Datenübertragung zwingend erforderlichen) ersten Leitungspaar als Bestandteil des Datenübertragungskanals bzw. der Schnittstelle noch ein zweites Leitungspaar (sowie gegebenenfalls auch ein drittes oder viertes Leitungspaar) vorhanden ist.

Hierzu kann die Detektionseinheit zur Erfassung einer Spannungsdifferenz zwischen den Leitungen des weiteren Leitungspaares eingerichtet sein, insbesondere unter Einschluss eines Vergleichs der ermittelten Spannungsdifferenz mit einem Schwellwert.

Konkret kann die Detektionseinheit z.B. derart ausgeführt sein, dass hiermit ein Abschlusswiderstand (Terminierungswiderstand) eines Leitungspaares auf Seiten der Steuer- bzw. Verarbeitungseinheit erfasst werden kann. Diese Ausgestaltung der Erfindung beruht auf der Erkenntnis, dass die serielle Übertragung von Daten zwischen einer Positionsmesseinrichtung und einer zugehörigen Steuer- bzw. Verarbeitungseinheit häufig differentiell erfolgt, z.B. nach dem RS-485-Standard. Bei einer differentiellen Datenübertragung ist der vorgenannte Abschluss- bzw. Terminierungswiderstand auf der Empfängerseite, also insbesondere auf Seiten einer Steuer- bzw. Verarbeitungseinheit, welche Positionsmesswerte empfangen soll, vorgesehen, um Reflektionen auf der Leitung zu vermeiden.

Die vorgenannte Erfindungsvariante ist ganz allgemein zur Erkennung eines Leitungspaares anwendbar, welches einen Abschluss- bzw. Terminierungswiderstand aufweist, so dass die Detektionseinheit durch Erfassung jenes Widerstandes auf das Vorhandensein eines entsprechenden Leitungspaares im Datenübertragungskanal bzw. in der Schnittstelle zwischen Positionsmesseinrichtung und Verarbeitungseinheit schließen kann.

Die Anwesenheit eines Terminierungswiderstandes in einem Leitungspaar auf Seiten der Verarbeitungseinheit lässt sich beispielsweise dadurch erfassen, dass mittels der Detektionseinheit geprüft wird, ob sich über einen Strompfad, in welchem bei Vorhandensein des entsprechenden Leitungspaares und des zugehörigen Terminierungswiderstandes der letztere liegen müsste, ein Stromkreis bilden lässt.

So können die Anwesenheit eines bestimmten Leitungspaares sowie des zugehörigen Terminierungswiderstandes mittels einer Detektionseinheit etwa durch versuchte Bestromung des Leitungspaares und des Terminierungswiderstandes einschließlich einer Strommessung und/oder durch versuchten Abgriff eines Spannungspegels an dem Terminierungswiderstand erfasst werden.

Speziell kann die Anwesenheit eines bestimmten Leitungspaares im Datenübertragungskanal bzw. in der Schnittstelle zwischen Positionsmesseinrichtung und Verarbeitungseinheit dadurch erfasst werden, dass die Detektionseinheit einen Komparator aufweist, der den Spannungspegel einer der Leitungen des Leitungspaares (mit welcher der Terminierungswiderstand verbunden ist) mit einem Referenzpegel vergleicht.

Nach einer weiteren Ausführungsform der Erfindung kann die Detektionseinheit ausgebildet sein zur Ermittlung (Messung) des Wellenwiderstandes bzw. der Impedanz oder der Reflektionseigenschaften der Leitungen des zu detektierenden weiteren Leitungspaares.

Ein Verfahren zur Ermittlung der Anzahl an Leitungspaaren, über die eine Positionsmesseinrichtung mit einer zugehörigen Steuer- bzw. Verarbeitungseinheit verbunden ist, ist durch die Merkmale des Anspruchs 16 gekennzeichnet. Weiterbildungen des Verfahrens sind in den hiervon abhängigen Ansprüchen angegeben.

Weitere Einzelheiten und Vorteile der Erfindung werden bei der nachfolgenden Beschreibung von Ausführungsbeispielen anhand der Figuren deutlich werden.

Es zeigen:
- Figur 1: eine Positionsmesseinrichtung und eine zugehörige Steuer- bzw. Verarbeitungseinheit, die über einen Datenübertragungskanal miteinander verbunden sind, als schematisiertes Blockdiagramm;
- Figur 2A: eine mögliche Ausgestaltung des Datenübertragungskanals aus Figur 1;
- Figur 2B: eine weitere mögliche Ausgestaltung des Datenübertragungskanals aus Figur 1;
- Figur 2C: noch eine weitere mögliche Ausgestaltung des Datenübertragungskanals aus Figur 1;
- Figur 3: eine erste Abwandlung der Positionsmesseinrichtung aus Figur 1 im Hinblick auf die Ausgestaltung einer Detektionseinheit;
- Figur 4: eine zweite Abwandlung der Positionsmesseinrichtung aus Figur 1 im Hinblick auf die Ausgestaltung einer Detektionseinheit.

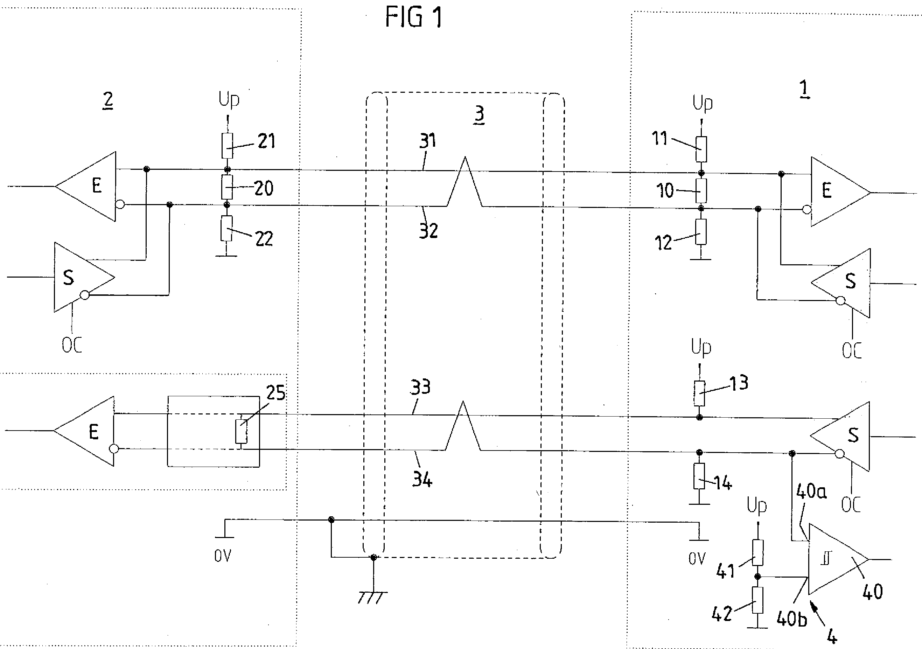

Figur 1 zeigt in einem Blockdiagramm eine Positionsmesseinrichtung 1 sowie eine Steuer- und Verarbeitungseinheit 2, zum Beispiel in Form einer numerischen Werkzeugmaschinensteuerung, die über einen Datenübertragungskanal 3 miteinander verbunden sind.

Die Positionsmesseinrichtung 1 und die Steuer- bzw. Verarbeitungseinheit 2 (nachfolgend kurz: Verarbeitungseinheit) können über den Datenübertragungskanal 3 Daten austauschen, zum Beispiel in Form von Positionsdaten (Positionsmesswerten), die von der Positionsmesseinrichtung 1 an die Verarbeitungseinheit 2 gesandt werden, sowie in Form von Befehlen, z. B. Positionsanforderungsbefehlen, die von der Verarbeitungseinheit 2 an die Positionsmesseinrichtung 1 gesandt werden. Der Datenübertragungskanal 3, welcher eine physikalische Verbindung zwischen der Positionsmesseinrichtung 1 und der Verarbeitungseinheit 2 zu Zwecken der Datenübertragung herstellt, sowie das Protokoll, welches die Regeln für jene Datenübertragung enthält (Schnittstellenprotokoll), werden dabei als Schnittstelle bezeichnet.

Für die Datenübertragung zwischen der Positionsmesseinrichtung 1 und der Verarbeitungseinheit 2 sind unterschiedliche Schnittstellenvarianten bekannt, die sich zum einen in der (physikalischen) Ausgestaltung des Datenübertragungskanales 3 und/oder zum anderen in dem zugehörigen Schnittstellenprotokoll unterscheiden können.

Der Datenübertragungskanal 3 bzw. die Schnittstelle insgesamt müssen in jedem Fall gewährleisten, dass von der Positionsmesseinrichtung 1 die in ihrem Betrieb erzeugten Ausgangssignale (Positionsmesswerte bzw. Positionsdaten) über den Datenübertragungskanal 3 an die zugehörige Verarbeitungseinheit 2 übertragen werden können. Darüber hinaus können der Datenübertragungskanal 3 sowie die hierdurch gebildete Schnittstelle die Übertragung weiterer Daten von der Positionsmesseinrichtung 1 zu der Verarbeitungseinheit 2 unterstützen bzw. zulassen, wie etwa die Übertragung von Temperaturdaten oder von Daten, die den Betriebszustand der Positionsmesseinrichtung 1 charakterisieren.

Weiterhin können der Datenübertragungskanal 3 sowie die hierdurch gebildete Schnittstelle auch die Übertragung von Daten von der Verarbeitungseinheit 2 zu der Positionsmesseinrichtung 1 zulassen, etwa in Form von Positionsanforderungsbefehlen, mit denen die Verarbeitungseinheit 2 aktuelle Positionsdaten von der Positionsmesseinrichtung 1 anfordert. Dies entspricht einer Ausgestaltung der Anordnung aus Figur 1 als sogenanntes Master-Slave-System, wobei die Verarbeitungseinheit 2 die Funktion des Masters und die Positionsmesseinrichtung 1 die Position des Slave übernimmt. D. h., die Datenübertragung zwischen jenen beiden Baugruppen 1, 2 wird jeweils durch die Verarbeitungseinheit 2 initiiert, z. B. durch das Senden von Positionsanforderungsbefehlen, während die Positionsmesseinrichtung 1 hierauf reagiert, z. B. durch das Senden aktueller Positionsdaten. Eine solche Ausgestaltung der Anordnung aus Figur 1 als Master-Slave-System ist aber vorliegend keinesfalls zwingend; entscheidend ist, dass zumindest die Ausgangssignale der Positionsmesseinrichtung 1 in Form von Positionsmesswerten (Positionsdaten) in geeigneter Weise von der Positionsmesseinrichtung 1 an die Verarbeitungseinheit 2 übertragen werden können.

Wie im Fall der Datenübertragung von der Positionsmesseinrichtung 1 zu der Verarbeitungseinheit 2, die neben den vorgenannten Positionsdaten noch die Übertragung weiterer Daten, wie z. B. Temperaturdaten, umfassen mag, kann auch die gegebenenfalls vorgesehene Datenübertragung von der Verarbeitungseinheit 2 zu der Positionsmesseinrichtung 1 einerseits mit der Positionsmessung verknüpfte Daten, wie z. B. die bereits erwähnten Positionsanforderungsbefehle, sowie andererseits weitere Daten, wie z. B. Parameterdaten, umfassen. Letztere können beispielsweise dazu dienen, der Positionsmesseinrichtung bestimmte Parameter zuzuführen, die für deren Betrieb von Bedeutung sind.

Die unterschiedlichen Daten, welche zwischen einer Positionsmesseinrichtung und einer Verarbeitungseinheit im Betrieb ausgetauscht werden können, sind allgemein bekannt und brauchen daher hier nicht näher erläutert zu werden. Lediglich beispielhaft sei diesbezüglich auf die EP 0 171 579 A1 und die EP 0 660 209 A1 verwiesen, wo die Datenübertragung zwischen einer Positionsmesseinrichtung und einer zugehörigen Verarbeitungseinheit für zwei unterschiedliche Schnittstellentypen im Einzelnen beschrieben ist.

Hier sei beispielhaft davon ausgegangen, dass die Positionsmesseinrichtung 2 durch Abtastung einer Maßverkörperung mittels einer Abtasteinheit Positionssignale erzeugt, welche in digitale Positionsmesswerte bzw. Positionsdaten umgewandelt und über den Datenübertragungskanal 3 an die Auswerteeinheit 2 übertragen werden. Das physikalische Prinzip, welches der Abtastung zugrunde liegt, ist dabei vorliegend nicht von Bedeutung; es können beispielsweise optische, magnetische oder induktive Messprinzipien angewandt werden. Neben den Positionsdaten können in der Positionsmesseinheit 1 noch weitere Daten erzeugt werden, wie z. B. aus der Relativbewegung zwischen Abtasteinheit und Maßverkörperung resultierende Messwerte, etwa Geschwindigkeit oder Beschleunigung. Bei den weiteren Daten kann es sich aber auch um Messwerte handeln, die Umgebungsbedingungen betreffen, wie z. B. Temperatur- oder Druckwerte. Schließlich können als weitere Daten auch Statusinformationen zur Verfügung gestellt werden, beispielsweise in Form von Statusbits oder Statusworten, die Warn- oder Fehlerzustände signalisieren.

Vorliegend geht es darum, mittels einer Detektionseinheit zu erkennen, über wie viele Leitungspaare (als Bestandteile des Datenübertragungskanales 3) die Positionsmesseinrichtung 1 und die Verarbeitungseinheit 2 miteinander verbunden sind, wofür die Art der über den Datenübertragungskanal 3 übertragenen Daten nicht von grundsätzlicher Bedeutung ist.

Im Blockdiagramm der Figur 1 sind von der Positionsmesseinrichtung 1 und der Verarbeitungseinheit 2 jeweils nur die Treiberbausteine (Sender S) und die Empfängerbausteine (Empfänger E) dargestellt, mit denen Daten gesandt bzw. empfangen werden können, wobei als Datenübertragungsmedium zwischen der Positionsmesseinrichtung 1 und der Verarbeitungseinheit 2 der Datenübertragungskanal 3 dient. Der grundsätzliche Aufbau einer Positionsmesseinrichtung sowie einer zugehörigen Verarbeitungseinheit sind ebenfalls allgemein bekannt und vielfach beschrieben sowie vorliegend hinsichtlich der Einzelheiten deshalb nicht von besonderem Interesse, weil es insbesondere um die Erkennung der Anzahl Leitungspaare 31, 32; 33, 34 der Übertragungseinheit 3 geht, nicht aber um Details zum Aufbau einer Positionsmesseinrichtung 1 und einer zugehörigen Verarbeitungseinheit 2. Von Bedeutung ist vielmehr, dass die Positionsmesseinrichtung 1 in der Lage ist, bei einer Positionsmessung erzeugte Ausgangssignale (Positionsmesswerte bzw. Positionsdaten) sowie gegebenenfalls weitere Daten über den Datenübertragungskanal 3 an die Verarbeitungseinheit 2 zu übertragen und dass die Verarbeitungseinheit 2 gegebenenfalls Befehle sowie weitere Daten an die Positionsmesseinrichtung 1 übertragen kann. Hierzu dienen die in Figur 1 jeweils dargestellten Sender- und Empfängerbausteine S, E der Positionsmesseinrichtung 1 und der Verarbeitungseinheit 2. Eine detailliertere Darstellung einer solchen Anordnung ist beispielsweise in der DE 10 2008 054 887 A1 zu finden.

Der Datenübertragungskanal 3 sei hier für eine serielle Datenübertragung ausgelegt. D.h., er umfasst zumindest eine serielle Datenverbindung. Vorliegend soll die Datenübertragung weiterhin differentiell, z. B. nach dem Standard RS-485, erfolgen. Somit ist eine jeweilige Datenverbindung des Datenübertragungskanals 3 als ein Leitungspaar 31, 32; 33, 34 ausgebildet, an das aufseiten der Positionsmesseinrichtung 1 und der Verarbeitungseinheit 2 jeweils die für die Datenübertragung erforderlichen Sender- und Empfängerbausteine S, E angeschlossen sind.

Ist zur Datenübertragung zwischen der Positionsmesseinrichtung 1 und der Verarbeitungseinheit 2 nur ein einzelnes (z.B. bidirektional betriebenes, differentielles) Leitungspaar vorgesehen, so wird von einer Zwei-Draht-Schnittstelle gesprochen. Schnittstellen, die auf einer Datenübertragung mittels zweier (differentieller) Leitungspaare beruhen, werden als Vier-Draht-Schnittstellen bezeichnet.

Gemäß Figur 1 sind den Leitungspaaren 31, 32; 33, 34 des Datenübertragungskanals 3 weiterhin jeweils sogenannte "Pull-up"-Widerstände 11, 13, 21 und "Pull-down"-Widerstände 12, 14, 22 zugeordnet, mit denen jeweils die eine Leitung 31 bzw. 33 eines jeweiligen Leitungspaares 31, 32; 33, 34 auf ein oberes elektrisches Potential (Spannungsniveau) und die andere Leitung 32, 34 des entsprechenden Leitungspaares 31, 32; 33, 34 auf ein unteres Potential, vorliegend auf Masse, gelegt wird.

Allgemeiner ausgedrückt, dienen die Widerstände 11, 12; 13, 14; 21, 22 dazu, die beiden Leitungen 31 und 32 bzw. 33 und 34 eines jeweiligen Leitungspaares im inaktiven (hochohmigen) Zustand der zugeordneten Senderbausteine S (welcher mittels des digitalen Pegels am entsprechenden Eingang OC des jeweiligen Senderbausteins bestimmt wird) jeweils auf ein definiertes elektrisches Potential zu legen.

Darüber hinaus ist den Leitungspaaren 31, 32 und 33, 34 jeweils an der Seite, an der Daten empfangen werden können, also im Fall des ersten Leitungspaares 31, 32 (bidirektional betriebene Datenleitung) sowohl aufseiten der Positionsmesseinrichtung 1 als auch aufseiten der Verarbeitungseinheit 2, sowie im Fall des zweiten Leitungspaares 33, 34 (unidirektional betriebene Datenleitung) lediglich aufseiten der Verarbeitungseinheit 2, jeweils ein Abschluss- bzw. Terminierungswiderstand 10, 20, 25 zugeordnet, um Signalreflektionen auf den besagten Leitungen dämpfen zu können. Im Ausführungsbeispiel der Figur 1 ist ein jeweiliger Terminierungswiderstand 10, 20, 25 jeweils an jede der beiden zugehörigen Leitungen 31 und 32 bzw. 33 und 34 des entsprechenden Leitungspaares angeschlossen.

Bei der in Figur 1 gezeigten Anordnung ist das erste Leitungspaar 31, 32 sowohl aufseiten der Positionsmesseinrichtung 1 als auch aufseiten der Verarbeitungseinheit 2 jeweils mit einem Sender S und einem Empfänger E verbunden, so dass dieses Leitungspaar 31, 32 bidirektional betrieben werden kann, was eine Datenübertragung sowohl von der Positionsmesseinrichtung 1 zur Verarbeitungseinheit 2 als auch umgekehrt von der Verarbeitungseinheit 2 zur Positionsmesseinrichtung 1 möglich ist. An das zweite Leitungspaar 33, 34 ist demgegenüber aufseiten der Positionsmesseinrichtung 1 lediglich ein Sender S und aufseiten der Verarbeitungseinheit 2 lediglich ein Empfänger E angeschlossen, so dass hier ausschließlich eine unidirektionale Datenübertragung von der Positionsmesseinrichtung 1zur Verarbeitungseinheit 2 möglich ist.

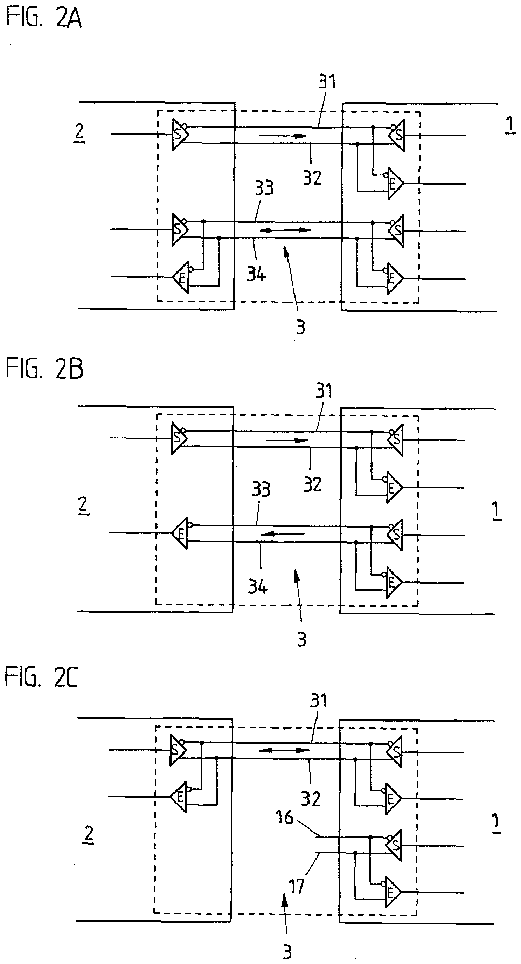

Bevor nachfolgend anhand Fig. 1 eine der Positionsmesseinrichtung 1 zugeordnete Detektionseinheit 4 näher erläutert werden wird, mittels der feststellbar ist, ob die Positionsmesseinrichtung 1 nur über das erste Leitungspaar 31, 32 oder zusätzlich auch über das zweite Leitungspaar 33, 34 mit der Verarbeitungseinheit 2 verbunden ist, werden zunächst anhand der Figuren 2A bis 2C drei bekannte Schnittstellenvarianten dargestellt, die der Verbindung zwischen einer Positionsmesseinrichtung 1 und einer Verarbeitungseinheit 2 dienen können. Dabei beruhen die Schnittstellen der Figuren 2A und 2B (als sogenannte 4-Draht-Schnittstellen) jeweils auf einer Verbindung zwischen Positionsmesseinrichtung 1 und Verarbeitungseinheit 2 über zwei Leitungspaare 31, 32; 33, 34, während die in Fig. 2C gezeigte Anordnung auf einer Verbindung von Positionsmesseinrichtung 1 und Verarbeitungseinheit 2 über nur ein Leitungspaar 31, 32 beruht (2-Draht-Schnittstelle).

In den rein schematischen Darstellungen der Figuren 2A bis 2C, welche dazu dienen, unterschiedliche Schnittstellenvarianten anhand der Anzahl an Leitungspaaren des Übertragungskanals 3 sowie der zugehörigen Sender S und Empfänger E zu verdeutlichen, sind die weiteren Bauelemente, einschließlich der in Fig. 1 gezeigten Widerstände, der Übersichtlichkeit halber weggelassen.

Die Positionsmesseinrichtung 1 ist bei den Ausführungsbeispielen der Figuren 2A bis 2C jeweils insoweit identisch ausgebildet, als dort jedem anzuschließenden Leitungspaar 31, 32 bzw. 33, 34 auf Seiten der Positionsmesseinrichtung jeweils ein Sender S und ein Empfänger E zugeordnet sind. Die jeweilige Positionsmesseinrichtung 1 ist also grundsätzlich dafür geeignet, über ein jeweils anzuschließendes Leitungspaar 31, 32 und/oder 33, 34 sowohl Daten an die Verarbeitungseinheit 2 zu senden als auch Daten von Letzterer zu empfangen.

Die einzelnen Anordnungen der Figuren 2A bis 2C unterscheiden sich jedoch darin, ob die jeweilige Positionsmesseinrichtung 1 über zwei Leitungspaare 31, 32; 33, 34 (im Fall der Figuren 2A und 2B) oder über nur ein Leitungspaar 31, 32 (im Fall der Fig. 2C) mit der zugehörigen Verarbeitungseinheit 2 verbunden ist. Außerdem unterscheiden sich die beiden erstgenannten Anordnungen mit 4-Draht-Schnittstelle, wie in den Fig. 2A und 2B dargestellt, untereinander darin, inwieweit ein jeweiliges Leitungspaar uni- oder bidirektional betrieben wird, was von der Ausgestaltung der jeweiligen Schnittstelle einschließlich der Anordnung von Sende- und Empfangsbausteinen S, E auf Seiten der Verarbeitungseinheit 2 abhängt.

Fig. 2A zeigt konkret eine Schnittstelle (EnDat) zwischen einer Positionsmesseinrichtung 1 und einer Verarbeitungseinheit 2 mit einem unidirektional betrieben ersten Leitungspaar 31, 32 und einem bidirektional betriebenen zweiten Leitungspaar 33, 34, wie etwa in der EP 0 660 209 A1 beschrieben. Das unidirektional betriebene Leitungspaar 31, 32 kann dabei insbesondere der Übertragung von Taktsignalen von der Verarbeitungseinheit 2 zu der Positionsmesseinrichtung 1 dienen, mittels welcher die Datenübertragung auf dem (bidirektional betriebenen) zweiten Leitungspaar 33, 34 synchronisiert wird.

Fig. 2B ist eine schematische Darstellung einer Schnittstelle (SSI) mit zwei unidirektional betriebenen Leitungspaaren 31, 32 und 33, 34, wie etwa in der EP 0 171 579 A1 beschrieben.

Und zu der in Fig. 2C gezeigten (2-Draht-)Schnittstelle, gemäß der die Positionsmesseinrichtung 1 und die Verarbeitungseinheit 2 lediglich über das erste (bidirektional ausgeführte) Leitungspaar 31, 32 verbunden sind, sei für weitere Einzelheiten auf die DE 10 2008 027 902 A1 verwiesen.

Vorliegend geht es darum, mittels einer der Positionsmesseinrichtung 1 zugeordneten Detektionseinheit, wie z. B. der in Fig. 1 beispielhaft gezeigten Detektionseinheit 4, festzustellen, über wie viele Leitungspaare des Datenübertragungskanals 3 die Positionsmesseinrichtung 1 mit der Verarbeitungseinheit 2 verbunden ist. Hierzu wird vorliegend der Umstand genutzt, dass bei einer (digitalen) Datenübertragung über Leitungspaare, z. B. der differentiellen Übertragung serieller Daten, auf Seiten eines jeweiligen Empfängers der über ein bestimmtes Leitungspaar 31, 32 oder 33, 34 übertragenen Daten regelmäßig ein Abschluss- bzw. Terminierungswiderstand angeordnet wird, um Signalreflektionen auf den betroffenen Leitungen zu dämpfen.

In Figur 1 ist beispielhaft eine Detektionseinheit 4 dargestellt, mit der erfassbar ist, ob das zweite Leitungspaar 33, 34 des Datenübertragungskanals 3 mit einem Terminierungswiderstand 25 auf Seiten der Verarbeitungseinheit 2 vorhanden ist. Ist ein solcher Widerstand 25 mittels der Detektionseinheit 4 detektierbar, so bedeutet dies, dass die Positionsmesseinrichtung 1 (auch) über das zweite Leitungspaar 33, 34 mit der Verarbeitungseinheit 2 verbunden ist, wie etwa im Fall der in den Figuren 2A und 2B dargestellten Schnittstellen.

Ist demgegenüber mittels der Detektionseinheit 4 kein dem zweiten Leitungspaar 33, 34 zugeordneter Terminierungswiderstand auf Seiten der Verarbeitungseinheit 2 detektierbar, so bedeutet dies, wie in Figur 2C dargestellt, dass an diejenigen Anschlussleitungen 16, 17 der Positionsmesseinrichtung, die dem Anschluss eines zweiten Leitungspaares 33, 34 zur Datenübertragung an die Verarbeitungseinheit 2 dienen, kein entsprechendes Leitungspaar angeschlossen ist.

Im Ausführungsbeispiel der Figur 1 ist die Detektionseinheit 4 dadurch realisiert, dass hiermit das elektrische Potential (der Spannungspegel) an einer Leitung 34 des zweiten Leitungspaares 33, 34 erfasst werden kann, wenn das zweite Leitungspaar 33, 34 (über die Anschlussleitungen 16, 17, vergleiche Fig. 2c) an die Positionsmesseinrichtung 1 angeschlossen ist und diese mit der Verarbeitungseinheit 2 verbindet.

Die Detektionseinheit 4 greift hierzu an denjenigen Anschluss 17, vergleiche Figur 2C, der Positionsmesseinrichtung 1 an, der bei Anwesenheit eines zweiten Leitungspaares 33, 34 mit der entsprechenden Leitung 34 jenes Paares zu verbinden ist.

Im Ausführungsbeispiel umfasst die Detektionseinheit 4 einen Komparator 40, dessen einer Eingang 40a über den entsprechenden Anschluss 17 der Positionsmesseinrichtung 1 an eine Leitung 34 des zweiten Leitungspaares 33, 34 angreift, sofern jenes Leitungspaar 33, 34 an die Positionsmesseinrichtung angeschlossen ist, und dessen anderer Eingang 40b auf einem Referenzpotential liegt, das hier beispielhaft durch zwei Widerstände 41, 42 zur Verfügung gestellt wird, die in Reihe geschaltet sind. Durch Vergleich des an dem einen Eingang 40a anliegenden Spannungspegels mit dem am anderen Eingang 40b anliegenden Referenzpegel erzeugt der Komparator 40 ein Ausgangssignal, welches angibt, ob der eine Eingang 40a mit einem Anschlussleitungspaar 33, 34 in Verbindung steht, dem wiederum ein Abschluss- bzw. Terminierungswiderstand 25 zugeordnet ist (welcher im Ausführungsbeispiel mit jeder der beiden Leitungen des besagten Anschlussleitungspaares 33, 34 verbunden ist).

In entsprechender Weise lässt sich mittels einer Detektionseinheit 4 für jedes beliebige Leitungspaar 31, 32; 33, 34 eines Datenübertragungskanals 3 feststellen, ob das entsprechende Leitungspaar zur Verbindung der Positionsmesseinrichtung 1 mit der Verarbeitungseinheit 2 vorhanden ist: Indem erfasst wird, ob an einer Detektionseinheit 4, die im Ausführungsbeispiel einen Komparator 40 aufweist und die an das jeweils zu detektierende Leitungspaar 31, 32 oder 33, 34 angreift, wenn dieses zur Verbindung der Positionsmesseinrichtung 1 mit der Verarbeitungseinheit 2 vorhanden ist, ein elektrisches Potential bzw. ein Spannungspegel registriert wird, der von einem dem entsprechenden Leitungspaar 33, 34 zugeordneten Abschluss- bzw. Terminierungswiderstand 25 herrührt.

Wie vorstehend bereits angegeben, wird die Detektion des Abschluss- bzw. Terminierungswiderstandes 25 vorteilhaft bei inaktiv (hochohmig) geschaltetem Treiberbaustein (Sender S) am entsprechenden Leitungspaar 33, 34 durchgeführt; im Fall der Figur 1 also z.B. bei einem inaktivem Sender S auf Seiten der Positionsmesseinrichtung 1. Hierdurch soll verhindert werden, dass der Sender S den Spannungspegel auf dem relevanten Leitungspaar 33, 34 beeinflusst.

Ist ein jeweiliger an das betrachtete Leitungspaar 33, 34 angeschlossener Sender S inaktiv bzw. hochohmig, so wird der Spannungspegel der Leitungen des betroffenen Leitungspaares 33, 34 vorliegend durch den "Pull-up"-Widerstand 13, den "Pull-down"-Widerstand 14 sowie, soweit vorhanden, durch den Abschluss- bzw. Terminierungswiderstand 25 bestimmt. Ohne den Terminierungswiderstand 25 (d. h., wenn keine Verbindung mit der Verarbeitungseinheit 2 über das zweite Leitungspaar 33, 34 vorliegt) wird ein Anschluss, welcher der einen Leitung 34 zugeordnet ist, durch den "Pull-down"-Widerstand 14 auf Massepotential gelegt und ein Anschluss, welcher der anderen Leitung 33 zugeordnet ist, durch den "Pull-up"-Widerstand 13 auf ein hiervon abweichendes Spannungspotential Uₚ gelegt. Wird dagegen über das zweite Leitungspaar 33, 34 eine Verbindung mit der Verarbeitungseinheit 2 hergestellt, so bilden die beiden vorgenannten Widerstände 13, 14 mit dem nun zusätzlich vorgesehenen Terminierungswiderstand 25 einen Spannungsteiler. Hierdurch kann beispielsweise bewirkt werden, dass das Potential an einer Leitung 34 angehoben und an der anderen Leitung 33 abgesenkt wird. Durch die Beeinflussung der Spannungspotentiale an den Leitungen des zu detektierenden Leitungspaares 33, 34 kann das Vorhandensein des Terminierungswiderstandes 25 erfasst werden.

Wäre demgegenüber der Sender S (hier auf Seiten der Positionsmesseinrichtung 1) aktiv geschaltet, d. h., würde dieser einen logischen High- oder Low-Pegel erzeugen, so würde das Potential der Leitungen des betrachteten Leitungspaares 33, 34 wesentlich durch den Sender S bestimmt und eine zuverlässige Detektion des Abschluss- bzw. Terminierungswiderstandes 25 mittels der Detektionseinheit 4 würde erschwert.

Alternativ zur Erfassung einer bestimmten Spannung bzw. eines Spannungspegels kann z.B. auch vorgesehen sein, ein Stromsignal (in der Positionsmesseinrichtung 1) zu erzeugen, das von dem entsprechenden Leitungspaar 33, 34 und dem zugehörigen Abschluss- bzw. Terminierungswiderstand 25 nach Art eines Stromkreises übertragen würde, sofern letztere an die Positionsmesseinrichtung 1 angeschlossen sind.

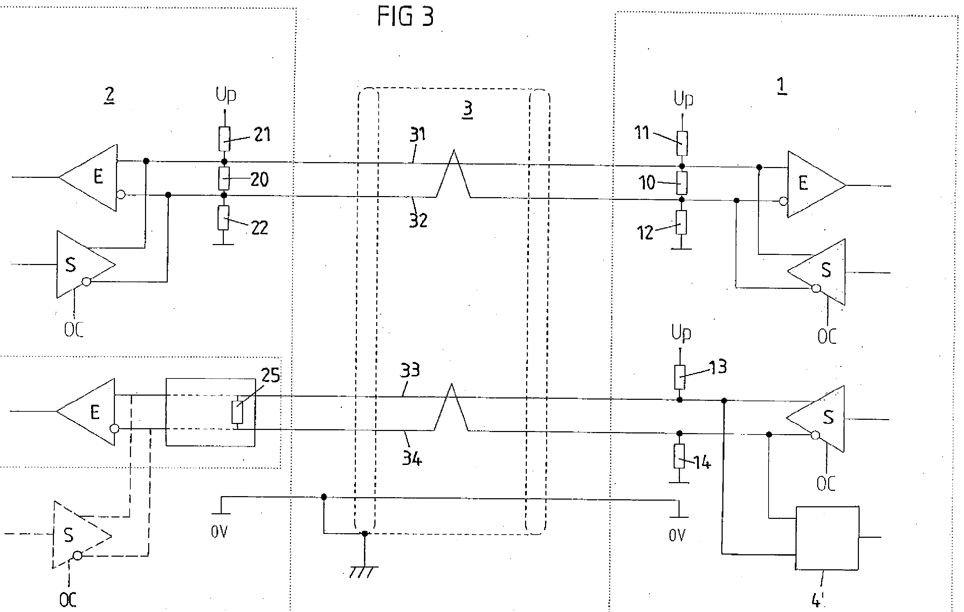

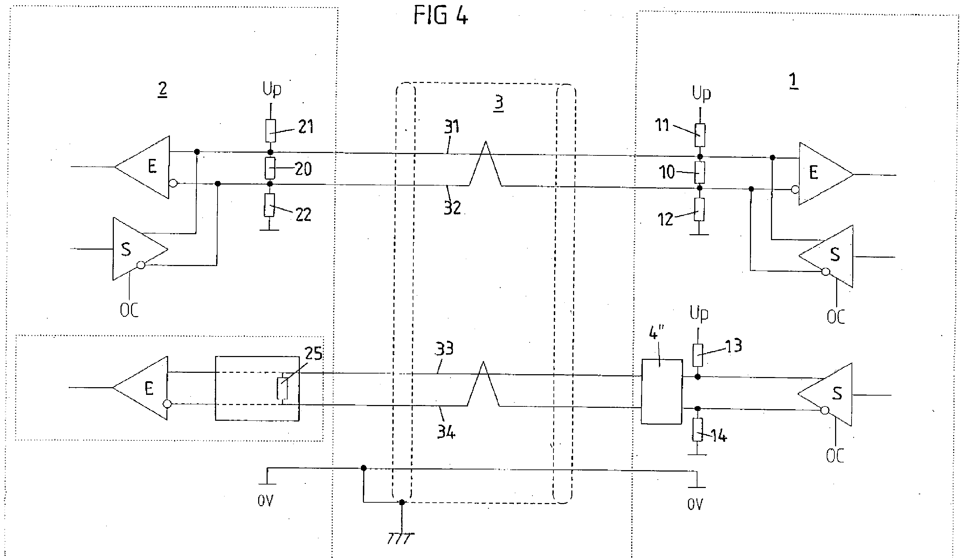

Anhand der Figuren 3 und 4 werden nachfolgend zwei Abwandlungen der Positionsmesseinrichtung aus Figur 1 beschrieben werden, und zwar jeweils mit Blick auf die Ausgestaltung der Detektionseinheit 4, mit welcher erfassbar ist, über wie viele Leitungspaare des Datenübertragungskanals 3 die Positionsmesseinrichtung 1 mit der zugehörigen Verarbeitungseinheit 2 verbunden ist. Beim ursprünglichen Ausführungsbeispiel der Figur 1 ist die Detektionseinheit 4 dabei eingerichtet zur Erfassung, ob die Positionsmesseinrichtung 1 (auch) über das zweite Leitungspaar 33, 34 des Datenübertragungskanales 3 mit der Verarbeitungseinheit 2 verbunden ist, und zwar durch Detektion eines (verarbeitungsseitigen) Terminierungswiderstandes 25.

Die in den Figuren 3 und 4 dargestellten Ausführungsbeispiele unterscheiden sich von der Anordnung aus Figur 1 jeweils in der Ausgestaltung der Detektionseinheit, welche in Figur 3 mit dem Bezugszeichen 4' und in Figur 4 mit dem Bezugszeichen 4" bezeichnet ist. Im Übrigen stimmen die Anordnungen der Figuren 3 und 4 mit der Anordnung aus Figur 1 überein; und es werden für übereinstimmende Bauelemente und Baugruppen in jenen Figuren jeweils die gleichen Bezugszeichen verwandt wie in Figur 1.

Gemäß Figur 3 ist als (der Positionsmesseinrichtung 1 zugeordneter) Detektionseinheit 4' eine Einheit zur Messung der Spannungsdifferenz zwischen den beiden Leitungen 33, 34 des entsprechenden (zweiten) Leitungspaares 33, 34 des Datenübertragungskanales 3 ausgebildet. Die mittels der Detektionseinheit 4' gemessene Spannungsdifferenz kann beispielsweise mit einem in der Detektionseinheit 4' (oder auch extern) gespeicherten Schwellwert verglichen werden oder in sonstiger Weise ausgewertet werden. Anhand der Spannungsdifferenz an den Anschlüssen 16, 17 der Positionsmesseinrichtung 1 (vergl. Figur 2c), über die mittels eines (zusätzlichen) zweiten Leitungspaares die Verarbeitungseinheit 2 anschließbar ist, lässt sich unmittelbar feststellen, ob eine solche Leitungsverbindung besteht oder nicht. Die Spannungsdifferenz an den beiden positionsmesseinrichtungsseitigen Anschlüssen 16, 17 für das zweite Leitungspaar 33, 34 hängt nämlich davon ab, ob dort tatsächlich ein Leitungspaar angeschlossen ist, über welches eine Verbindung mit der Verarbeitungseinheit hergestellt wird, oder nicht.

Hiermit lässt sich nicht nur (bei inaktivem Senderbaustein S auf Seiten der Positionsmesseinrichtung 1) ein etwaiger Abschlusswiderstand 25 erkennen, der (auf Seiten der Verarbeitungseinheit 2) zwischen den Leitungen des zweiten Leitungspaares 33, 34 angeordnet ist; sondern es kann beispielsweise auch unmittelbar ein aktiver Senderbaustein S (auf Seiten der Verarbeitungseinheit 2), wie in Figur 3 gestrichelt angedeutet, erkannt werden, der über das zweite Leitungspaar 33, 34 an die Positionsmesseinrichtung 1 angeschlossen ist.

Die unmittelbare Detektion eines über das zweite Leitungspaar 33, 34 angeschlossenen, verarbeitungsseitigen Senderbausteins S ist zwar grundsätzlich auch mittels der in Figur 1 gezeigten Detektionseinheit 4, welche als wesentliche Komponente einen Komparator 40 umfasst, möglich; hiermit ist jedoch zusätzlicher Aufwand verbunden. Da Senderbausteine regelmäßig differenzielle (nicht massebezogene) Signale übertragen, kann nicht ohne weiteres davon ausgegangen werden, dass bei der Anordnung aus Figur 1 die Spannung an dem als Abgriff fungierenden Eingang 40a des Komparators 40 dem am anderen Eingang 40b liegenden Schwellwert der Spannung zuverlässig überschreitet - je nach Wahl des Schwellwertes. Es kann mithin schwierig sein, bei der Anordnung aus Figur 1 den Schwellwert so festzulegen, dass ein aktiver Senderbaustein S auf Seiten der Verarbeitungseinheit 2 zuverlässig erkannt wird.

Bei dem in Figur 4 dargestellten Ausführungsbeispiel ist die Detektionseinheit 4" (auf Seiten des Positionsmesssystems 1) als Einrichtung zur Messung des Wellenwiderstandes bzw. der Impedanz oder der Reflektionseigenschaften der Leitungen des zu detektierenden (zweiten) Leitungspaares 33, 34 ausgebildet. Hiermit lässt sich sowohl feststellen, ob das zweite Leitungspaar 33, 34 an die Positionsmesseinrichtung 1 angeschlossen ist, als auch ermitteln, ob ein jenem Leitungspaar zugeordneter Abschlusswiderstand 25 tatsächlich (in der Schaltung) vorgesehen ist.

## Patentansprüche

1. Positionsmesseinrichtung (1) zur Bestimmung der Lage zweier zueinander bewegbarer Objekte, die im Betrieb Daten in Form von Positionsmesswerten erzeugt und die zur Übertragung von Daten über einen Datenübertragungskanal (3) mit einer Verarbeitungseinheit (2) zu verbinden ist, wobei die Verbindung der Positionsmesseinrichtung (1) mit der Verarbeitungseinheit (2) wahlweise über ein erstes Leitungspaar (31, 32) oder über ein erstes Leitungspaar (31, 32) und ein weiteres Leitungspaar (33, 34) erfolgen kann,
**dadurch gekennzeichnet,**
**dass** der Positionsmesseinrichtung (1) eine Detektionseinheit (4, 4', 4") zugeordnet ist, die einen Bestandteil der Positionsmesseinrichtung (1) bildet und mit der das Vorhandensein oder Nicht-Vorhandensein des weiteren Leitungspaares (33, 34) erfassbar ist, wenn die Positionsmesseinrichtung (1) über den Datenübertragungskanal (3) mit der Verarbeitungseinheit (2) verbunden ist, wobei die Detektionseinheit (4, 4', 4") ausgebildet ist zur Erfassung eines Abschlusswiderstandes (25), der bei Vorhandensein des weiteren Leitungspaares (33, 34) aufseiten der Verarbeitungseinheit (2) vorgesehen ist und die Leitungen des weiteren Leitungspaares (33, 34) miteinander verbindet.

2. Positionsmesseinrichtung nach Anspruch 1, **dadurch gekennzeichnet, dass** die Detektionseinheit (4, 4', 4") ausgebildet ist zur Erfassung, ob an mindestens einem vorgebbaren Anschluss (16,17) der Positionsmesseinrichtung (1) das weitere Leitungspaar (33, 34) angeschlossen ist oder nicht, das die Positionsmesseinrichtung (1) mit der Verarbeitungseinheit (2) verbindet.

3. Positionsmesseinrichtung nach einem der vorhergehenden Ansprüche, **dadurch gekennzeichnet, dass** die Detektionseinheit (4, 4') ausgebildet ist zur Bestimmung der Spannungsdifferenz zwischen den Leitungen des weiteren Leitungspaares (33, 34).

4. Positionsmesseinrichtung nach Anspruch 3, **dadurch gekennzeichnet, dass** die Detektionseinheit (4, 4') ausgebildet ist zum Vergleich der Spannungsdifferenz mit einem Schwellwert.

5. Positionsmesseinrichtung nach einem der vorhergehenden Ansprüche, **dadurch gekennzeichnet, dass** die Detektionseinheit (4) das Vorhandensein des weiteren Leitungspaares (33, 34) durch eine Prüfung erfasst, ob das Leitungspaar (33, 34) und der Abschlusswiderstand (25) einen Stromkreis bilden.

6. Positionsmesseinrichtung nach Anspruch 5, **dadurch gekennzeichnet, dass** die Detektionseinheit (4, 4', 4") erfasst, ob an den Anschluss (16, 17) der Positionsmesseinrichtung (1) ein Stromkreis (33, 25, 34) angeschlossen ist.

7. Positionsmesseinrichtung nach einem der vorhergehenden Ansprüche, **dadurch gekennzeichnet, dass** die Detektionseinheit (4, 4') ein elektrisches Potential erfasst, das bei Vorhandensein des Abschlusswiderstandes (25) modifiziert wird.

8. Positionsmesseinrichtung nach Anspruch 7, **dadurch gekennzeichnet, dass** die Detektionseinheit (4) einen Komparator (40) umfasst, der das elektrische Potential, welches bei Vorhandensein des Abschlusswiderstandes (25) modifiziert wird, mit einem Referenzpotential vergleicht.

9. Positionsmesseinrichtung nach Anspruch 8, **dadurch gekennzeichnet, dass** ein Eingang (40a) des Komparators (40) mit einer Anschlussleitung (17) des Anschlusses (16, 17) der Positionsmesseinrichtung (1) verbunden ist und ein anderer Eingang (40b) des Komparators (40) mit einem Referenzpotentialgeber (41, 42) verbunden ist.

10. Positionsmesseinrichtung nach einem der Ansprüche 1 bis 2, **dadurch gekennzeichnet, dass** die Detektionseinheit (4") ausgebildet ist zur Erfassung des Wellenwiderstandes und/oder der Reflektionseigenschaften des weiteren Leitungspaares (33, 34).

11. Verfahren zum Detektieren einer Anzahl an Leitungspaaren (31, 32; 33, 34), über die eine Positionsmesseinrichtung (1) mit einer Verarbeitungseinheit (2) verbunden ist, um im Betrieb Daten zwischen der Positionsmesseinrichtung (1) und der Verarbeitungseinheit (2) übertragen zu können, wobei die Verbindung der Positionsmesseinrichtung (1) mit der Verarbeitungseinheit (2) zum bestimmungsgemäßen Betrieb wahlweise über ein erstes Leitungspaar (31, 32) oder über ein erstes Leitungspaar (31, 32) und ein weiteres Leitungspaar (33, 34) erfolgt,
**dadurch gekennzeichnet,**
**dass** der Positionsmesseinrichtung (1) eine Detektionseinheit (4, 4', 4") zugeordnet ist, die einen Bestandteil der Positionsmesseinrichtung (1) bildet und mit der das Vorhandensein oder Nicht-Vorhandensein des weiteren Leitungspaares (33, 34) erfasst wird, wenn die Positionsmesseinrichtung (1) zur Datenübertragung bestimmungsgemäß mit der Verarbeitungseinheit (2) verbunden ist, wobei die Detektionseinheit (4, 4', 4") ausgebildet ist zur Erfassung eines Abschlusswiderstandes (25), der bei Vorhandensein des weiteren Leitungspaares (33, 34) aufseiten der Verarbeitungseinheit (2) vorgesehen ist und die Leitungen des weiteren Leitungspaares (33, 34) miteinander verbindet.

12. Verfahren nach Anspruch 11, **dadurch gekennzeichnet, dass** mittels der Detektionseinheit (4, 4', 4") erfasst wird, ob an mindestens einem vorgebbaren Anschluss (16, 17) der Positionsmesseinrichtung (1) das weitere Leitungspaar (33, 34) angeschlossen ist oder nicht, das die Positionsmesseinrichtung (1) mit der Verarbeitungseinheit (2) verbindet.

13. Verfahren nach einem der Ansprüche 11 bis 12, **dadurch gekennzeichnet, dass** die Detektionseinheit (4) einen Komparator (40) umfasst, der ein elektrisches Potential, welches bei Vorhandensein des Terminierungswiderstandes (25) modifiziert wird, mit einem Referenzpotential vergleicht.

14. Verfahren nach einem der Ansprüche 11 bis 13 unter Verwendung einer Positionsmesseinrichtung nach mindestens einem der Ansprüche 1 bis 10.

## Claims

1. Position measuring device (1) for determining the position of two objects which can be moved with respect to one another, which position measuring device generates data in the form of position measured values during operation and is to be connected to a processing unit (2) in order to transmit data via a data transmission channel (3), the position measuring device (1) being able to be connected to the processing unit (2) either via a first line pair (31, 32) or via a first line pair (31, 32) and a further line pair (33, 34),
**characterized**
**in that** the position measuring device (1) is assigned a detection unit (4, 4', 4") which forms part of the position measuring device (1) and can be used to detect the presence or absence of the further line pair (33, 34) when the position measuring device (1) is connected to the processing unit (2) via the data transmission channel (3), the detection unit (4, 4', 4") being designed to detect a terminating resistor (25) which is provided on the side of the processing unit (2) when the further line pair (33, 34) is present and connects the lines in the further line pair (33, 34) to one another.

2. Position measuring device according to Claim 1, **characterized in that** the detection unit (4, 4', 4") is designed to detect whether or not the further line pair (33, 34) which connects the position measuring device (1) to the processing unit (2) is connected to at least one predefinable connection (16, 17) of the position measuring device (1).

3. Position measuring device according to one of the preceding claims, **characterized in that** the detection unit (4, 4') is designed to determine the voltage difference between the lines in the further line pair (33, 34).

4. Position measuring device according to Claim 3, **characterized in that** the detection unit (4, 4') is designed to compare the voltage difference with a threshold value.

5. Position measuring device according to one of the preceding claims, **characterized in that** the detection unit (4) detects the presence of the further line pair (33, 34) by checking whether the line pair (33, 34) and the terminating resistor (25) form a circuit.

6. Position measuring device according to Claim 5, **characterized in that** the detection unit (4, 4', 4") detects whether a circuit (33, 25, 34) is connected to the connection (16, 17) of the position measuring device (1).

7. Position measuring device according to one of the preceding claims, **characterized in that** the detection unit (4, 4') detects an electrical potential which is modified when the terminating resistor (25) is present.

8. Position measuring device according to Claim 7, **characterized in that** the detection unit (4) comprises a comparator (40) which compares the electrical potential, which is modified when the terminating resistor (25) is present, with a reference potential.

9. Position measuring device according to Claim 8, **characterized in that** one input (40a) of the comparator (40) is connected to a connection line (17) of the connection (16, 17) of the position measuring device (1) and another input (40b) of the comparator (40) is connected to a reference potential generator (41, 42).

10. Position measuring device according to either of Claims 1 and 2, **characterized in that** the detection unit (4") is designed to detect the characteristic impedance and/or the reflection properties of the further line pair (33, 34).

11. Method for detecting a number of line pairs (31, 32; 33, 34) used to connect a position measuring device (1) to a processing unit (2) in order to be able to transmit data between the position measuring device (1) and the processing unit (2) during operation, the position measuring device (1) being connected to the processing unit (2) for intended operation either via a first line pair (31, 32) or via a first line pair (31, 32) and a further line pair (33, 34),
**characterized**
**in that** the position measuring device (1) is assigned a detection unit (4, 4', 4") which forms part of the position measuring device (1) and is used to detect the presence or absence of the further line pair (33, 34) when the position measuring device (1) is connected to the processing unit (2) as intended for data transmission, the detection unit (4, 4', 4") being designed to detect a terminating resistor (25) which is provided on the side of the processing unit (2) when the further line pair (33, 34) is present and connects the lines in the further line pair (33, 34) to one another.

12. Method according to Claim 11, **characterized in that** the detection unit (4, 4', 4") is used to detect whether or not the further line pair (33, 34) which connects the position measuring device (1) to the processing unit (2) is connected to at least one predefinable connection (16, 17) of the position measuring device (1).

13. Method according to either of Claims 11 and 12, **characterized in that** the detection unit (4) comprises a comparator (40) which compares an electrical potential, which is modified when the terminating resistor (25) is present, with a reference potential.

14. Method according to one of Claims 11 to 13 using a position measuring device according to at least one of Claims 1 to 10.

## Revendications

1. Dispositif de mesure de position (1) destiné à déterminer la position de deux objets mobiles l'un par rapport à l'autre, qui génère en fonctionnement des données sous la forme de valeurs de mesure de position et qui est à relier à une unité de traitement (2) en vue de la transmission de données par le biais d'un canal de transmission de données (3), la liaison du dispositif de mesure de position (1) avec l'unité de traitement (2) pouvant être effectuée, au choix, par le biais d'une première paire de lignes (31, 32) ou par le biais d'une première paire de lignes (31, 32) et d'une paire de lignes supplémentaire (33, 34),
**caractérisé en ce**
**qu'**une unité de détection (4, 4', 4") est associée au dispositif de mesure de position (1), laquelle forme un élément constitutif du dispositif de mesure de position (1) et avec laquelle peut être détectée la présence ou l'absence de la paire de lignes supplémentaire (33, 34) lorsque le dispositif de mesure de position (1) est relié à l'unité de traitement (2) par le biais du canal de transmission de données (3), l'unité de détection (4, 4', 4") étant configurée pour détecter une résistance de terminaison (25) qui est présente du côté de l'unité de traitement (2) lorsque la paire de lignes supplémentaire (33, 34) est présente et qui relie entre elles les lignes de la paire de lignes supplémentaire (33, 34).

2. Dispositif de mesure de position selon la revendication 1, **caractérisé en ce que** l'unité de détection (4, 4', 4") est configurée pour détecter si la paire de lignes supplémentaire (33, 34) est raccordée ou non à au moins une borne (16, 17) pouvant être prédéfinie du dispositif de mesure de position (1), laquelle paire relie le dispositif de mesure de position (1) à l'unité de traitement (2).

3. Dispositif de mesure de position selon l'une des revendications précédentes, **caractérisé en ce que** l'unité de détection (4, 4') est configurée pour déterminer la différence de tension entre les lignes de la paire de lignes supplémentaire (33, 34).

4. Dispositif de mesure de position selon la revendication 3, **caractérisé en ce que** l'unité de détection (4, 4') est configurée pour comparer la différence de tension avec une valeur de seuil.

5. Dispositif de mesure de position selon l'une des revendications précédentes, **caractérisé en ce que** l'unité de détection (4) détecte la présence de la paire de lignes supplémentaire (33, 34) par contrôle destiné à vérifier si la paire de lignes (33, 34) et la résistance de terminaison (25) forment un circuit électrique.

6. Dispositif de mesure de position selon la revendication 5, **caractérisé en ce que** l'unité de détection (4, 4', 4") détecte si un circuit électrique (33, 25, 34) est raccordé à la borne (16, 17) du dispositif de mesure de position (1).

7. Dispositif de mesure de position selon l'une des revendications précédentes, **caractérisé en ce que** l'unité de détection (4, 4') détecte un potentiel électrique qui est modifié en présence de la résistance de terminaison (25).

8. Dispositif de mesure de position selon la revendication 7, **caractérisé en ce que** l'unité de détection (4) comprend un comparateur (40) qui compare avec un potentiel de référence le potentiel électrique qui est modifié en présence de la résistance de terminaison (25).

9. Dispositif de mesure de position selon la revendication 8, **caractérisé en ce qu'**une entrée (40a) du comparateur (40) est reliée à une ligne de raccordement (17) de la borne (16, 17) du dispositif de mesure de position (1) et une autre entrée (40b) du comparateur (40) est reliée à un générateur de potentiel de référence (41, 42).

10. Dispositif de mesure de position selon l'une des revendications 1 à 2, **caractérisé en ce que** l'unité de détection (4") est configurée pour détecter l'impédance et/ou les propriétés de réflexion de la paire de lignes supplémentaire (33, 34).

11. Procédé de détection d'un nombre de paires de lignes (31, 32 ; 33, 34) par le biais desquelles un dispositif de mesure de position (1) est relié à une unité de traitement (2) afin de pouvoir transmettre, en fonctionnement, des données entre le dispositif de mesure de position (1) et l'unité de traitement (2), la liaison du dispositif de mesure de position (1) avec l'unité de traitement (2) en vue d'un fonctionnement conformément à l'usage prévu pouvant être effectuée, au choix, par le biais d'une première paire de lignes (31, 32) ou par le biais d'une première paire de lignes (31, 32) et d'une paire de lignes supplémentaire (33, 34), **caractérisé en ce**
**qu'**une unité de détection (4, 4', 4") est associée au dispositif de mesure de position (1), laquelle forme un élément constitutif du dispositif de mesure de position (1) et avec laquelle peut être détectée la présence ou l'absence de la paire de lignes supplémentaire (33, 34) lorsque le dispositif de mesure de position (1) est relié à l'unité de traitement (2) conformément à l'usage prévu en vue de la transmission de données, l'unité de détection (4, 4', 4") étant configurée pour détecter une résistance de terminaison (25) qui est présente du côté de l'unité de traitement (2) lorsque la paire de lignes supplémentaire (33, 34) est présente et qui relie entre elles les lignes de la paire de lignes supplémentaire (33, 34).

12. Procédé selon la revendication 11, **caractérisé en ce que** l'unité de détection (4, 4', 4") est utilisée pour détecter si la paire de lignes supplémentaire (33, 34) est raccordée ou non à au moins une borne (16, 17) pouvant être prédéfinie du dispositif de mesure de position (1), laquelle relie le dispositif de mesure de position (1) à l'unité de traitement (2).

13. Procédé selon l'une des revendications 11 à 12, **caractérisé en ce que** l'unité de détection (4) comprend un comparateur (40) qui compare avec un potentiel de référence le potentiel électrique qui est modifié en présence de la résistance de terminaison (25).

14. Procédé selon l'une des revendications 11 à 13 en utilisant un dispositif de mesure de position selon au moins l'une des revendications 1 à 10.
